(19) Europäisches Patentamt
European Patent Office
Office européen des brevets

(11) EP 2 308 904 A1

(12) **EUROPEAN PATENT APPLICATION**
published in accordance with Art. 153(4) EPC

(43) Date of publication:
**13.04.2011 Bulletin 2011/15**

(21) Application number: **09802911.9**

(22) Date of filing: **27.07.2009**

(51) Int Cl.:
***C08F 220/10*** *(2006.01)* ***C08J 3/12*** *(2006.01)*

(86) International application number:
**PCT/JP2009/063339**

(87) International publication number:
**WO 2010/013668 (04.02.2010 Gazette 2010/05)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **31.07.2008 JP 2008198037**
**29.09.2008 JP 2008250510**
**23.01.2009 JP 2009013417**

(71) Applicant: **Sekisui Chemical Co., Ltd.**
**Osaka 530-8565 (JP)**

(72) Inventors:
- **WADA, Takuya**
**Mishima-gun**
**Osaka 618-8589 (JP)**
- **NAGATANI, Naoyuki**
**Mishima-gun**
**Osaka 618-8589 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

# (54) POLYMER PARTICLE, CONDUCTIVE PARTICLE, ANISOTROPIC CONDUCTIVE MATERIAL AND CONNECTION STRUCTURE

(57) An object of the present invention is to provide a polymer particulate material with a low compression modulus and a high recovery rate from compression deformation.

The present invention provides a polymer particulate material obtainable by co-polymerizing comonomer components including a polyfunctional (meth)acrylate having a structure represented by the below formulas (1), (2) or (3), and a monofunctional (meth)acrylate monomer having a structure represented by the below formula (4), the polymer particulate material shows a recovery rate from compressive deformation of 70% or higher:

EP 2 308 904 A1

[Chemical formula 1]

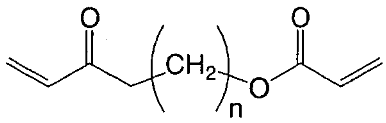

(1)

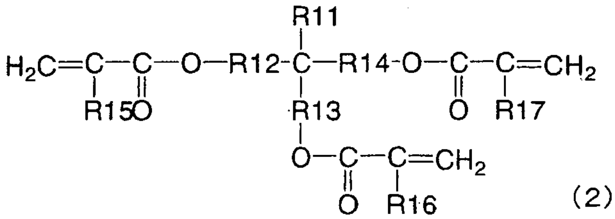

(2)

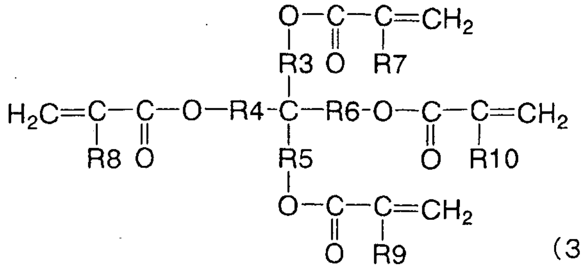

(3)

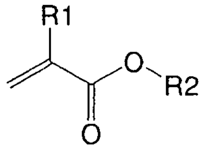

(4)

In the formula (1), n represents an integer within the range of 4 to 10. In the formula (2), R11 represents a hydrogen atom or a C1-4 alkyl group, R12, R13 and R14 each represent a C1-4 alkylene group, and R15, R16 and R17 each represent a hydrogen atom or a methyl group. In the formula (3), R3, R4, R5 and R6 each represent a C1-4 alkylene group, and R7, R8, R9 and R10 each represent a hydrogen atom or a methyl group. In the formula (4), R1 represents a hydrogen atom or a methyl group, and R2 represents a C5-18 alkyl group.

[FIG. 1]

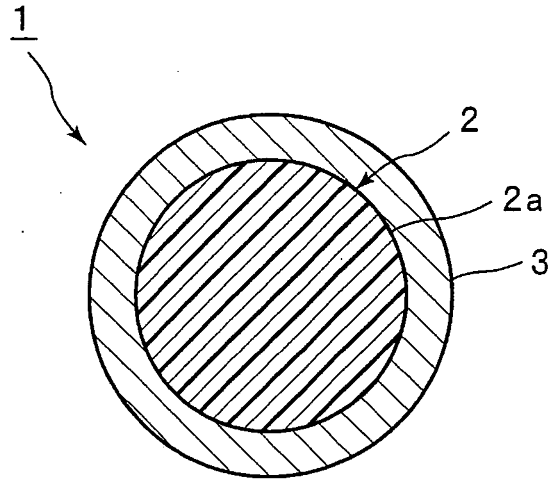

## Description

### TECHNICAL FIELD

The present invention relates to a polymer particulate material formed by copolymerization of monomers. The polymer particulate material can be used, for example, to produce an electroconductive particulate material for connecting electrodes of members to be connected. The present invention also relates to an electroconductive particulate material, an anisotropic conductive material, and a connection structure which include the polymer particulate material.

### BACKGROUND ART

Anisotropic conductive materials such as anisotropic conductive pastes, anisotropic conductive inks, anisotropic conductive adhesives, anisotropic conductive films or anisotropic conductive sheets have been known widely. These anisotropic conductive materials contain electroconductive particles which are dispersed in a paste, ink or resin.

Anisotropic conductive materials are used for connection between an IC chip and a flexible printed circuit board, or between an IC chip and a circuit board provided with an ITO electrode. For example, electrodes of an IC chip and a circuit board can be electrically connected by placing an anisotropic conductive material between the electrodes, and then heating and compressing.

As an example of electroconductive particulate materials to be used for producing the anisotropic conductive material, patent document 1, which is listed below, discloses an electroconductive particulate material, in which the surface of a resin particle is covered with an electroconductive layer. The main ingredient of the resin particle is an acrylic resin. The acrylic resin is constituted of a polymer produced from monomer mixture which contains urethane compounds and acrylates. The maximum compression deformation of this resin particles is 60% or higher. The load necessary to compressively deform the resin particle to the level of 60% compression deformation is 60 mN or lower.

Patent document 1: WO 03/104285

### SUMMARY OF INVENTION

### PROBLEM WHICH THE INVENTION IS TO SOLVE

Generally, on connection between electrodes of circuit boards or electronic parts using an electroconductive particle or an anisotropic conductive material that contains the electroconductive particle, an electroconductive particle is nipped between the electrodes, and then a load is applied on the electroconductive particle to compress the particle. The electroconductive particle is deformed by compression. At this time, the electroconductive particle is necessary to deform sufficiently so as to make the contacting area between the electroconductive particle and electrode wider. Thus, electroconductive particulate materials with a low compression modulus are greatly demanded.

After connection between electrodes, the load to compress the particle is removed. Then, the deformed electroconductive particle has to recover to the undeformed original shape to a certain degree because slight gap may occur at the interface of the electrode and the electroconductive particle, and as a result, connection resistance between the electrodes may increase.

The electroconductive particulate material disclosed in the Patent document 1 has not shown a sufficiently low compression modulus and a sufficiently high recovery rate from compression deformation. Thus, the contacting area of an electroconductive particle and an electrode may not be sufficiently larger when electrodes of circuit boards or electronic parts are connected by electroconductive particles. In addition, electroconductive particles deformed by the compression load may not be sufficiently recovered to the original shape. Thus, electric connection failures between electrodes may be easy to occur, and therefore high connection reliability has not been attained.

Furthermore, the specific gravity of a resin particulate material that has a low compression modulus and a high recovery rate from compression deformation sometimes becomes relatively lower. Thus, it is sometimes difficult to sufficiently disperse such a resin particulate material in an aqueous solution. Use of a dispersion in which resin particles are not sufficiently dispersed may fail to form an even electroconductive layer on the surface of resin particles by electroless plating.

An object of the present invention is to provide a polymer particulate material with low a compression modulus and a high recovery rate from compression deformation, which is employable to form an electroconductive particulate material, for example, and can enhance connection reliability when electrodes are connected each other via the electroconductive particulate material. Another object of the present invention is to provide an electroconductive particulate material, an anisotropic conductive material, and a connection structure which include the polymer particulate material.

## MEANS FOR SOLVING THE PROBLEM

According to a broad aspect of the present invention, the present invention provides a polymer particulate material obtainable by co-polymerizing comonomer components comprising:

at least one polyfunctional (meth) acrylate selected from the group consisting of a bifunctional (meth)acrylate monomer having a structure represented by the below formula (1), a trifunctional (meth)acrylate monomer having a structure represented by the below formula (2), and a tetrafunctional (meth)acrylate monomer having a structure represented by the below formula (3); and
a monofunctional (meth)acrylate monomer having a structure represented by the below formula (4),
wherein, if the at least one polyfunctional (meth)acrylate comprises the tetrafunctional (meth)acrylate monomer having a structure represented by the below formula (3), the comonomer components comprises 80% by weight or less of the monofunctional (meth) acrylate monomer in 100% by weight as the total weight of the tetrafunctional (meth) acrylate monomer and the monofunctional (meth)acrylate monomer, and
the polymer particulate material shows a recovery rate from compressive deformation of 70% or higher;

[Chemical formula 1]

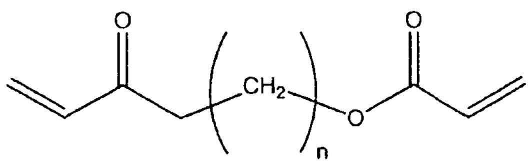

··· Formula (1)

in the formula (1), n represents an integer within the range of 4 to 10;
[Chemical formula 2]

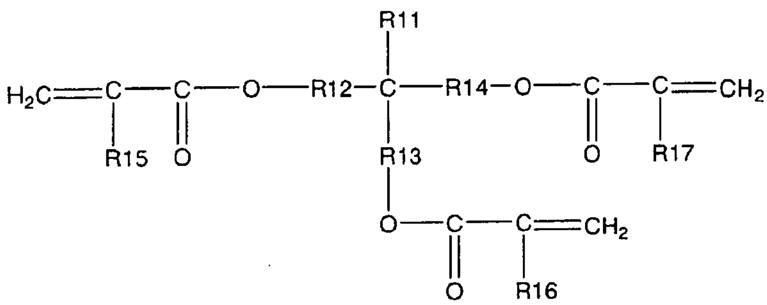

··· Formula (2)

in the formula (2), R11 represents a hydrogen atom or a C1-4 alkyl group, R12, R13 and R14 each represent a C1-4 alkylene group, and R15, R16 and R17 each represent a hydrogen atom or a methyl group;
[Chemical formula 3]

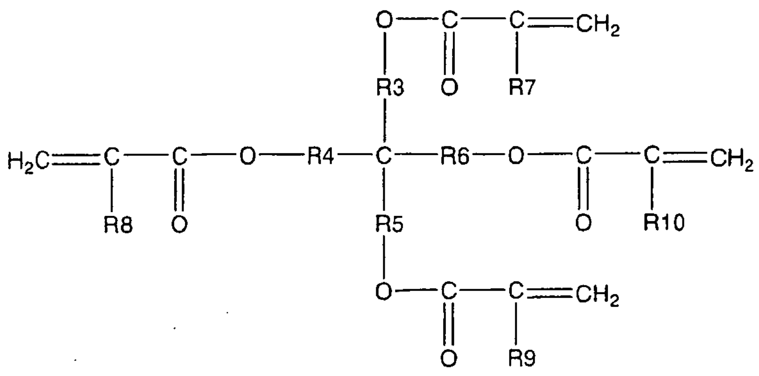

··· Formula (3)

in the formula (3), R3, R4, R5 and R6 each represent a C1-4 alkylene group, and R7, R8, R9 and R10 each represent a hydrogen atom or a methyl group; and

[Chemical formula 4]

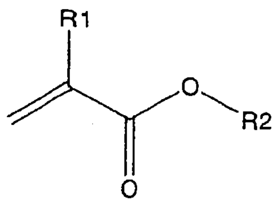

··· Formula (4)

in the formula (4), R1 represents a hydrogen atom or a methyl group, and R2 represents a C5-18 alkyl group, wherein the alkyl group may have a linear structure or a branched chain structure.

In a specific aspect of the polymer particulate material according to the present invention, the polyfunctional (meth) acrylate is the tetrafunctional (meth) acrylate monomer.

In another specific aspect of the polymer particulate material according to the present invention, the comonomer components contains 70% by weight or less of the monofunctional (meth) acrylate monomer in the 100% by weight as the total weight of the tetrafunctional (meth) acrylate monomer and the monofunctional (meth)acrylate monomer.

In another specific aspect of the polymer particulate material according to the present invention, the monofunctional (meth)acrylate monomer is at least one of the group selected from the group consisting of lauryl (meth)acrylate, stearyl (meth)acrylate, isostearyl (meth)acrylate, and isoamyl (meth)acrylate.

In still another specific aspect of the polymer particulate material according to the present invention, the monofunctional (meth) acrylate monomer is at least one of lauryl (meth)acrylate and stearyl (meth)acrylate.

In another specific aspect of the polymer particulate material according to the present invention, the polyfunctional (meth)acrylate is the bifunctional (meth)acrylate monomer.

In still another specific aspect of the polymer particulate material according to the present invention, the comonomer components contains the monofunctional (meth)acrylate monomer in an amount within the range of 10 to 400 parts by weight relative to 100 parts by weight of the bifunctional (meth)acrylate monomer.

In still another specific aspect of the polymer particulate material according to the present invention, the polyfunctional (meth)acrylate is the trifunctional (meth)acrylate monomer.

An electroconductive particulate material of the present invention includes the polymer particulate material constituted according to the present invention, and an electroconductive layer that covers the surface of the polymer particulate material.

In a specific aspect of the electroconductive particulate material according to the present invention, the outer

surface of the electroconductive layer is a solder layer.

An anisotropic conductive material of the present invention contains the electroconductive particulate material constituted according to the present invention, and a binder resin.

A connection structure according to the present invention includes a first member to be connected; a second member to be connected; and a connection part that electrically connects the first member and the second member, wherein the connection part is formed from the electroconductive particulate material constituted according to the present invention, or an anisotropic conductive material that includes the electroconductive particulate material and a binder resin.

## EFFECT OF THE INVENTION

According to the present invention, the polymer particulate material is obtained by copolymerizing comonomer components including a polyfunctional (meth)acrylate monomer having a structure represented by any one of the formulas (1) to (3), and a monofunctional (meth)acrylate monomers having a structure represented by the formula (4). Thus, the compression modulus of the polymer particulate material can be made lower. The recovery rate of the polymer particulate material according to the present invention from compression deformation is 70% or higher. The recovery rate from compression deformation is high.

Thus, connection reliability can be higher in a case where the polymer particulate material according to the present invention is used to form the electroconductive particulate material, and then electrodes are connected one another via the electroconductive particulate material.

In a case where the polyfunctional (meth) acrylate includes the tetrafunctional (meth)acrylate monomer represented by the formula (3), the comonomer components containing 80% by weight or less of the monofunctional (meth) acrylate monomer in 100% by weight as the total weight of the tetrafunctional (meth)acrylate monomer and the monofunctional (meth)acrylate monomer are able to make the specific gravity of the polymer particulate material higher.

In a case where at least one (meth)acrylate of the group consisting of lauryl (meth)acrylate, stearyl (meth) acrylate, isostearyl (meth)acrylate, and isoamyl (meth)acrylate is used as the monofunctional (meth)acrylate monomer, the compression modulus of the polymer particulate material becomes further lower and the recovery rate thereof from compression deformation becomes further higher. Also, the volume expansion rate of the polymer particulate material according to the present invention becomes further lower.

## BRIEF DESCRIPTION OF THE DRAWINGS

Fig. 1 is a cross-sectional view illustrating an electroconductive particle, in which the surface of the polymer particulate material of one embodiment of the present invention is covered with an electroconductive layer.

Fig. 2 is a cross-sectional view illustrating an alternative example of an electroconductive particle that has the polymer particulate material of one embodiment of the present invention.

Fig. 3 is a front cross-sectional view schematically illustrating a connection structure, and the connection structure includes an electroconductive particle in which the surface of the polymer particulate material of one embodiment of the present invention is covered with an electroconductive layer.

Fig. 4 (a) and (b) are graphs each illustrating the results of measurement of the 10%K value and the recovery rate from compression deformation of the polymer particulate material in Example 10.

Fig. 5 (a) and (b) are graphs each illustrating the results of measurement of the 10%K value and the recovery rate from compression deformation of the polymer particulate material in Example 14.

Fig. 6 (a) and (b) are graphs each illustrating the results of measurement of the 10%K value and the recovery rate from compression deformation of the polymer particulate material in Comparative Example 5.

Fig. 7 (a) and (b) are graphs each illustrating the results of measurement of the 10%K value and the recovery rate from compression deformation of the polymer particulate material in Comparative Example 6.

## MODE FOR CARRYING OUT THE INVENTION

The present inventors have found that a polymer particulate material with a low compression modulus and a high recovery rate from compression deformation can be obtained by co-polymerizing comonomer components that contains a polyfunctional (meth)acrylate monomer having a chemical structure represented by any one of the formulas (1) to (3), and a monofunctional (meth) acrylate monomer having a chemical structure represented by the formula (4), thus completing the present invention.

The present inventors have also found that, if the polyfunctional (meth)acrylate contains a tetrafunctional (meth) acrylate monomer having a chemical structure represented by the below formula (3), the comonomer components

comprising 80% by weight or less of the monofunctional (meth)acrylate monomer in 100% by weight as the total weight of the tetrafunctional (meth) acrylate monomer and the monofunctional (meth) acrylate monomer provides a polymer particulate material with a higher specific gravity.

The present inventors have also found that use of at least one of the group selected from the group consisting of lauryl (meth)acrylate, stearyl (meth)acrylate, isostearyl (meth)acrylate, and isoamyl (meth)acrylate as the monofunctional (meth)acrylate monomer provides a polymer particulate material with a lower compression modulus, a higher recovery rate from compression deformation, and a lower volume expansion rate. Particularly, at least one of lauryl (meth)acrylate and stearyl (meth)acrylate as the monofunctional (meth)acrylate monomer can provide a polymer particulate material with a further lower compression modulus, a further higher recovery rate from compression deformation, and a further lower volume expansion rate.

The present invention will be described below in detail.

(Polymer particulate material)

The polymer particulate material according to the present invention is a polymer particulate material obtainable by co-polymerizing comonomer components that includes:

- at least one polyfunctional (meth) acrylate selected from the group consisting of a bifunctional (meth)acrylate monomer having a structure represented by the below formula (1), a trifunctional (meth)acrylate monomer having a structure represented by the below formula (2), and a tetrafunctional (meth)acrylate monomer having a structure represented by the below formula (3); and
- a monofunctional (meth)acrylate monomer having a structure represented by the below formula (4).

[Chemical formula 5]

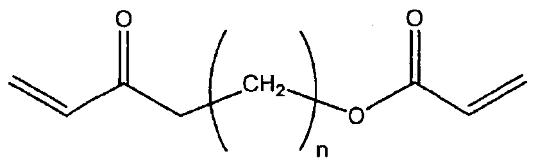

··· Formula (1)

In the formula (1), n represents an integer within the range of 4 to 10.

[Chemical formula 6]

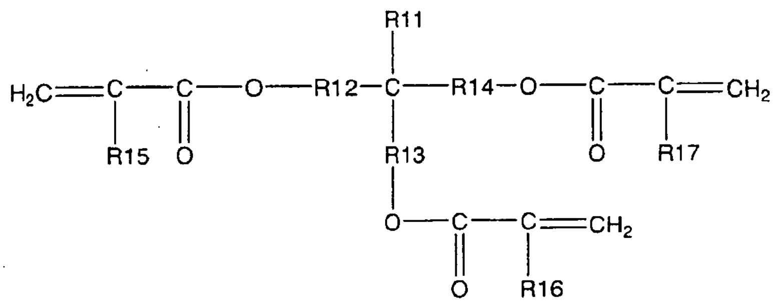

··· Formula (2)

In the formula (2), R11 represents a hydrogen atom or a C1-4 alkyl group, R12, R13 and R14 each represent a C1-4 alkylene group, and R15, R16 and R17 each represent a hydrogen atom or a methyl group.

[Chemical formula 7]

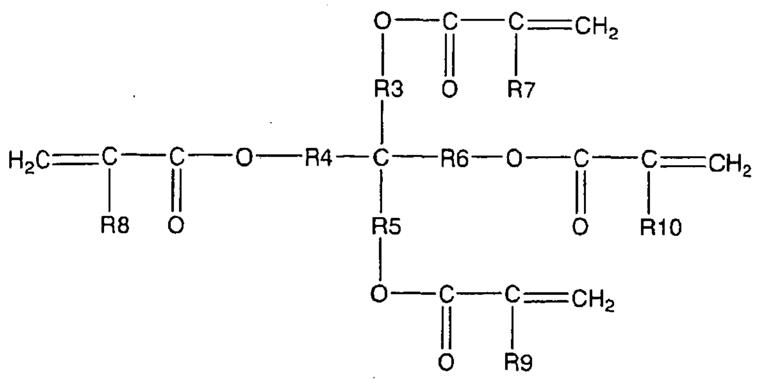

··· Formula (3)

In the formula (3), R3, R4, R5 and R6 each represent a C1-4 alkylene group, and R7, R8, R9 and R10 each represent a hydrogen atom or a methyl group.

[Chemical formula 8]

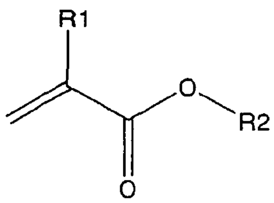

··· Formula (4)

In the formula(4), R1 represents a hydrogen atom or a methyl group, and R2 represents a C5-18 alkyl group, wherein the alkyl group may have a linear structure or a branched chain structure.

Herein, the term "(meth)acrylate" means both or either of a methacrylate and an acrylate.

The polymer particulate material according to the present invention is preferably used to cover the surface of the polymer particulate material with an electroconductive layer, and thereby obtain an electroconductive particulate material.

The bifunctional (meth)acrylate monomer which is employable for producing the polymer particulate material is a (meth) acrylate monomer having a structure represented by the formula (1). The bifunctional (meth)acrylate monomer may be used singly or in combination of two or more species.

The "n" in the formula (1) is preferably 10. In other words, the bifunctional (meth)acrylate monomer is preferably 1,10-decanediol di(meth)acrylate. In this case, the volume expansion rate of the polymer particulate material exposed to a high temperature may be lower. Thus, the electroconductive particulate material including the polymer particulate material may be resistant to cracking or exfoliation in the electroconductive layer even if the electroconductive particulate material are exposed to a step performed in a high temperature condition such as reflowing.

The trifunctional (meth) acrylate monomer, which is employable for producing the polymer particulate material is a (meth) acrylate monomer having a structure represented by the formula (2). The trifunctional (meth)acrylate monomer may be used singly or in combination of two or more species.

The trifunctional (meth)acrylate monomer is not particularly limited. The trifunctional (meth)acrylate monomer is preferably trimethylolpropane tri(meth)acrylate, and more preferably trimethylolpropane triacrylate. Such a preferable monomer contributes to make the specific gravity of the polymer particulate material further higher.

The R11 in the formula (2) represents a hydrogen atom or a C1-4 alkyl group. The R11 in the formula (2) is preferably a methyl or ethyl group.

The R12, R13 and R14 in the formula (2) independently represent a C1-4 alkylene group. Each of the R12,

R13 and R14 in the formula (2) is preferably a C1-3 alkylene group, and more preferably a methylene group. The R12, R13 and R14 in the formula (2) may be the same as or different from one another.

The R15, R16 and R17 in the formula (2) independently represent a hydrogen atom or a methyl group. If all of the R15, R16 and R17 in the formula (2) are hydrogen atoms, the trifunctional (meth)acrylate monomer means an acrylate monomer. If all of the R15, R16 and R17 in the formula (2) are methyl groups, the trifunctional (meth) acrylate monomer means a methacrylate monomer. The R15, R16 and R17 in the formula (2) may be the same as or different from one another. The trifunctional (meth) acrylate monomer may have an acryloyl group and a methacryloyl group.

The tetrafunctional (meth) acrylate monomer, which is employable for producing the polymer particulate material, is a (meth)acrylate monomer having a structure represented by the formula (3). The tetrafunctional (meth)acrylate monomer may be used singly or in combination of two or more species.

The tetrafunctional (meth)acrylate monomer is preferably pentaerythritol tetra(meth)acrylate. Such pentaerythritol tetra(meth)acrylate contributes to make the specific gravity of the polymer particulate material higher. Thus, dispersibility of the polymer particulate material in a plating solution can be higher. Therefore, an electroconductive layer can easily be formed on the surface of the polymer particulate material.

The R3, R4, R5 and R6 in the formula (2) independently represent a C1-4 alkylene group. Each of the R3, R4, R5 and R6 in the formula (2) is preferably a C1-3 alkylene group, and more preferably methylene group. The R3, R4, R5 and R6 may be the same as or different from one another.

The R7, R8, R9 and R10 in the formula (3) independently represent a hydrogen atom or a methyl group. If all of the R7, R8, R9 and R10 in the formula (3) are hydrogen atoms, the tetrafunctional (meth)acrylate monomer is an acrylate monomer. If all of the R7, R8, R9 and R10 in the formula (3) are methyl groups, the tetrafunctional (meth)acrylate monomer is a methacrylate monomer. The R7, R8, R9 and R10 may be the same as or different from one another. The tetrafunctional (meth)acrylate monomer may have an acryloyl group and a methacryloyl group.

The monofunctional (meth)acrylate monomer, which is employable for producing the polymer particulate material is a (meth) acrylate monomer having a structure represented by the formula (4).

If the R1 in the formula (4) is a hydrogen atom, the monofunctional (meth)acrylate monomer means an acrylate monomer. If the R1 in the formula (4) is a methyl group, the monofunctional (meth)acrylate monomer is a methacrylate monomer.

The R2 in the formula (4) represents a C5-18 alkyl group. The preferable lower limit of the number of the carbon atoms is 12.

The R2, namely the above C5-18 alkyl group may have a linear structure or a branched chain structure. A linear C5-18 alkyl group as R2 contributes to make the recovery rate of the polymer particulate material from compression deformation remarkably higher.

The monofunctional (meth)acrylate having a structure represented by the formula (1) monomer is preferably at least one of the group selected from the group consisting of lauryl (meth)acrylate, stearyl (meth)acrylate, isostearyl (meth)acrylate, and isoamyl (meth)acrylate. Such (meth)acrylates contribute to make the recovery rate of the polymer particulate material from compression deformation further higher. For example, the recovery rate from compression deformation can be enhanced to be 90% or higher.

Furthermore, the monofunctional (meth)acrylate monomer is more preferably at least one of lauryl (meth) acrylate and stearyl (meth)acrylate. Such more preferable monomers contribute to make the recovery rate of the polymer particulate material from compression deformation further higher. For example, the recovery rate from compression deformation can be enhanced to be 95% or higher.

Copolymerization of comonomer components including the above-mentioned polyfunctional (meth)acrylate monomer having a structure represented by any one of the formulas (1) to (3), and the above-mentioned monofunctional (meth) acrylate monomer yields a polymer particulate material.

If the polyfunctional (meth)acrylate monomer contains the bifunctional (meth)acrylate monomer having a structure represented by the formula (1), the monofunctional (meth)acrylate monomer content in the comonomer components is preferably within the range of 10 to 400 parts by weight, and more preferably within the range of 10 to 100 parts by weight, relative to 100 parts by weight of the bifunctional (meth) acrylate monomer. If the monofunctional (meth) acrylate monomer content is very low, the effect of lowering the compression modulus or the effect of enhancing the recovery rate from compression deformation may be insufficient. Thus, connection reliability may become lower in the case where the electroconductive particulate material is used for connection between electrodes. If the monofunctional (meth)acrylate monomer content is very large, the bifunctional (meth) acrylate monomer content becomes relatively lower, thus results in larger volume expansion rate of the polymer particulate material when the polymer particulate material was exposed to a high temperature condition.

In the case where the polyfunctional (meth)acrylate monomer includes the trifunctional (meth)acrylate monomer having a structure represented by the formula (2), the monofunctional (meth) acrylate monomer content in the comonomer components is preferably within the range of 10 to 400 parts by weight, and more preferably within the range of 20 to 200 parts by weight, relative to 100 parts by weight of the trifunctional (meth)acrylate monomer. If the monofunctional

(meth) acrylate monomer content is very low, the effect of lowering the compression modulus or the effect of enhancing the recovery rate from compression deformation may be insufficient. Thus, connection reliability may become lower in the case where the electroconductive particulate material is used for connection between electrodes. If the monofunctional (meth)acrylate monomer content is very large, the trifunctional (meth)acrylate monomer content becomes relatively lower, thus results in decrease of the specific gravity of the polymer particulate material. As a result, dispersibility of the polymer particulate material in plating solution decreases, and therefore, it becomes difficult to form an electroconductive layer on the surface of the polymer particulate material. The volume expansion rate of the polymer particulate material exposed to a high temperature condition may become higher.

The specific gravity of the polymer particulate material tends to be higher when the polyfunctional (meth)acrylate monomer contains a tetrafunctional (meth)acrylate monomer having a structure represented by the formula (3). To increase the specific gravity of the polymer particulate material to a sufficient level, when the polyfunctional (meth) acrylate monomer contains a tetrafunctional (meth)acrylate monomer having a structure represented by the formula (3), the comonomer components contains 80% by weight or less of the monofunctional (meth) acrylate monomer in the total weight, as 100% by weight, of the tetrafunctional (meth)acrylate monomer and the monofunctional (meth) acrylate monomer. If the monofunctional (meth)acrylate monomer content is very high, the specific gravity of the polymer particulate material becomes low. Thus, it becomes difficult to form an even electroconductive layer on the surface of the polymer particulate material.

The comonomer components may preferably contain 80% by weight or less of the monofunctional (meth) acrylate monomer in the total weight, as 100% by weight, of the tetrafunctional (meth) acrylate monomer and the monofunctional (meth) acrylate monomer. If the monofunctional (meth) acrylate monomer content is within the above range, the specific gravity of a polymer particulate material produced may become further higher, and thus a much evener electroconductive layer can be formed on the surface of the polymer particulate material.

Since the specific gravity of the polymer particulate material may be made further higher, the monofunctional (meth) acrylate monomer content in the comonomer components is more preferably 60% by weight or less, and still more preferably 50% by weight or less, relative to the total weight, as 100% by weight, of the tetrafunctional (meth) acrylate monomer and the monofunctional (meth)acrylate monomer.

In the case where the polyfunctional (meth)acrylate monomer contains a tetrafunctional (meth)acrylate monomer having a structure represented by the formula (3), the lower limit of the monofunctional (meth)acrylate monomer is not particularly limited. The monofunctional (meth) acrylate monomer content in the comonomer components is preferably 5% by weight or more, more preferably 10% by weight ore more, and still more preferably 25% by weight or more, relative to the total weight, as 100% by weight, of the tetrafunctional (meth)acrylate monomer and the monofunctional (meth)acrylate monomer. The monofunctional (meth)acrylate monomer content of 10% by weight or more may contribute to increase the recovery rate of the polymer particulate material from compression deformation. The monofunctional (meth)acrylate monomer content of 25% by weight or more may contribute to remarkable increase of the recovery rate of the polymer particulate material from compression deformation. For example, the recovery rate from compression deformation of 90% or higher is easily possible.

Another or other monomer(s) than the monomers mentioned above may be used as the comonomer components. The other monomer(s) may be used singly or in combination of two or more species.

Examples of the other monomer(s) include conjugated dienes, diallyl phthalate, triallyl isocyanurate, divinylbenzene, styrene, styrene derivatives, vinyl chloride, vinyl esters, and unsaturated nitriles.

Examples of the conjugated dienes include butadiene, and isoprene. Examples of the styrene derivatives include $\alpha$-methylstyrene, p-methylstyrene, p-chlorostyrene, and chloromethylstyrene. Examples of the vinyl esters include vinyl acetate, and vinyl propionate. Examples of the unsaturated nitriles include acrylonitrile.

Examples of the other monomer(s) include pentaerythritol tri(meth)acrylate, dipentaerythritol hexa(meth)acrylate, methyl (meth)acrylate, ethyl (meth)acrylate, butyl (meth)acrylate, ethylene glycol (meth)acrylate, trifluoroethyl (meth)acrylate, pentafluoropropyl (meth)acrylate, and cyclohexyl (meth)acrylate.

The comonomer components may also contain, as the other monomer(s), another or other monomer(s) such as a bifunctional (meth)acrylate monomer other than the bifunctional (meth)acrylate monomer having a structure represented by the formula (1), a trifunctional (meth)acrylate monomer other than trifunctional (meth) acrylate monomer having a structure represented by the formula (2), or a tetrafunctional (meth)acrylate monomer other than tetrafunctional (meth)acrylate monomer having a structure represented by the formula (3).

The other monomer may be used, if needed, in an amount of 400 parts by weight or less relative to 100 parts by weight of the polyfunctional (meth)acrylate monomers. The upper limit of the amount of the other monomer is preferably 100 parts by weight, more preferably 80 parts by weight, particularly preferably 50 parts by weight, and still more preferably 10 parts by weight, relative to 100 parts by weight of the polyfunctional (meth)acrylate monomers. If the other monomer content is very high, lowering effect of the compression modulus of the polymer particulate material may be insufficient, or the enhancing effect of the recovery rate of the polymer particulate material from compression deformation may be insufficient. The specific gravity-increasing effect of the polymer particulate material may sometimes insufficient when

the polyfunctional (meth)acrylate monomer contains the tetrafunctional (meth)acrylate monomer.

A variety of polymerization initiators are used in the production of the polymer particulate material. The polymerization initiator is not particularly limited. Specific examples of the polymerization initiators include persulfates, organic peroxides, and azo compounds. The polymerization initiators may be used singly or in combination of two or more species. Among the polymerization initiators, organic peroxides are preferable as the polymerization initiator because such organic peroxides contribute to increase the recovery rate of the polymer particulate material from compression deformation.

Examples of the persulfates include potassium persulfate, sodium persulfate, and ammonium persulfate. Examples of the organic peroxides include cumene hydroperoxide, benzoyl peroxide, lauroyl peroxide, octanoyl peroxide, o-chlorobenzoyl peroxide, acetyl peroxide, t-butyl hydroperoxide, t-butyl peroxyacetate, t-butyl peroxyisobutyrate, 3,5,5-trimethylhexanoyl peroxide, t-butyl peroxy-2-ethylhexanoate, and di-t-butyl peroxide. Examples of the azo compounds include 2,2'-azobisisobutyronitrile, 2,2'-azobis(2,4-dimethylvaleronitrile), 4,4'-azobis (4-cyanopentanoic acid), 2,2'-azobis(2-methyl butyronitrile), and azobis(cyclohexanecarbonitrile).

The amount of the polymerization initiator to be added is preferably within the range of 0. 05 to 5 parts by weight relative to the total weight, as 100 parts by weight, of the polyfunctional (meth)acrylate monomer and the monofunctional (meth)acrylate monomer. The amount of the polymerization initiator to be added is preferably within the range of 0.05 to 5 parts by weight relative to the weight, as 100 parts by weight, of the comonomer components. If the amount of the polymerization initiator is very low, polymerization reaction may be insufficient, or may require a long period of time for polymerization. If the amount of the polymerization initiator is very large, polymerization may be rapidly proceeded, which results in formation of agglomerate.

The method of polymerization for producing the polymer particulate material is not particularly limited. Specific examples of the method of polymerization include conventionally-known polymerization such as suspension polymerization, emulsion polymerization, seed polymerization, and dispersion polymerization.

The suspension polymerization and emulsion polymerization can provide a polydisperse polymer particulate material with a relatively broad distribution of particle diameters. Thus, the suspension polymerization and emulsion polymerization are suitable for producing a fine particulate material having a wide variety of particle diameters. In employing suspension polymerization, it is preferable to classify the obtained polymer particulate material to separate polymer particles with a desired particle diameter and a particle diameter distribution.

In a seed polymerization, a monodisperse polymer particulate material may be produced without classification. Thus, the seed polymerization is suitable for large scale production of a polymer particulate material with a specific particle diameter.

Solvents employable in the polymerization are suitably selectable depending on the type of the monomers, and are not particularly limited. Examples of the solvents include water, alcohols, cellosolves, ketones, and acetates. Another or other solvent (s) than the solvents above listed may be used. The solvents may be used singly or used in combination of two or more species.

Examples of the alcohols include methanol, ethanol, and propanol. Examples of the above cellosolves include methyl cellosolve and ethyl cellosolve. Examples of the ketones include acetone, methyl ethyl ketone, methyl butyl ketone, and 2-butanone. Examples of the acetates include ethyl acetate, and butyl acetate. Examples of the other solvent include acetonitrile, N,N-dimethyl formamide, and dimethyl sulfoxide.

The compression modulus (10%K value) of the polymer particulate material according to the present invention, namely a compression modulus when the diameter of a polymer particle in the material decreases by 10% by deformation is preferably within the range of 5 to 3,000 N/mm$^2$. The lower limit of the range of the compression modulus (10%K value) is more preferably 10 N/mm$^2$, and still more preferably 20 N/mm$^2$. The upper limit of the range is more preferably 2,000 N/mm$^2$, particularly preferably 500 N/mm$^2$, further preferably 350 N/mm$^2$, and still more preferably 100 N/mm$^2$. If the compression modulus (10%K value) is very low, polymer particles may break by compression. If the compression modulus (10%K value) is very large, deformation of polymer particles by compression may be insufficient. Thus, contacting area of an electroconductive particle and an electrode may become small if electrodes are connected to one another, resulting in decreased connection reliability.

The compression modulus (10%K value) may be determined according to the following manner:

A polymer particle is compressed with a flat surface end of a diamond cylindrical compressing device (diameter: 50μ m) of a Micro Compression Testing Machine (manufactured by Shimadzu Corporation, PCT-100) in a condition of compression rate of 2. 65 mN/sec and maximum testing load of 10 grams. Load value and compression deformation is then measured. Based on the measured value, the compression modulus (10%K value) when the diameter of a polymer particle in the material decreases by 10% by deformation can be calculated by the following formula:

$$K\ value\ (N/mm^2) = (3/2^{1/2}) \cdot F \cdot S^{-3/2} \cdot R^{-1/2}$$

F: Load value (N) when the diameter of the polymer particle decreases by 10% by deformation
S: Compression deformation(mm)when the diameter of the polymer particle decreases by 10% by deformation
R: Radius of the polymer particle (mm)

The 10%K value indicates hardness of a polymer particle universally and quantitatively. Hardness of the polymer particulate material can be indicated by the 10%K value quantitatively and unambiguously.
The recovery rate of the polymer particulate material from compression deformation is 70% or higher. The recovery rate is preferably 75% or higher, more preferably 80% or higher, particularly preferably 90% or higher, still more preferably 95% or higher, and most preferably 98% or higher. If the recovery rate from compression deformation is very low, recovery of a polymer particle from a deformed state by compression to the original state may be insufficient. Thus, a slight gap may be formed between an electrode and an electroconductive particle when electrodes are connected to one another via the electroconductive particulate material, which causes high resistance between electrodes.
The recovery rate from compression deformation may be determined as follows:
In a Micro Compression Testing Machine (manufactured by Shimadzu Corporation, PCT-100), a polymer particle is loaded at the loading rate of 0.284 mN/sec starting from an initial load value (a load value required for setting the sample at the original position (0.0039 N)) to a load where the diameter of the polymer particle decreases by 12.5% by deformation. The load where the diameter of the polymer particle decreases by 12.5% by deformation is referred to as a reverse compression load value. Then, the load applied on the polymer particle is released to an initial load value (0.0039 N) at a load-releasing rate of 0.284 mN/sec. Variation of the load and compression displacement during this cycle is determined. Based on the value thus-determined, the recovery rate from compression deformation can be calculated by the following formula:
$$\text{Recovery rate from compression deformation (\%)} = [(L1-L2)/L1] \times 100$$

L1: Compression displacement (mm) on loading from the original position at the initial load value to the position at the reverse compression load value
L2: Compression displacement (mm) on releasing from the position at the reverse compression load value to the position at the initial load value

The specific gravity of the polymer particulate material is preferably 1.05 or larger, more preferably 1.07 or larger, and still more preferably 1.10 or larger. The larger the specific gravity of the polymer particulate material is, the easier it is to evenly form an electroconductive layer on the surface of the polymer particulate material.
The specific gravity of the polymer particulate material can be measured using a Micromeritics Gas Pycnometer (manufactured by Shimadzu Corporation, "Accupyc 1330") under helium gas atmosphere at a pressure of 0.15 to 0.17 MPa.
The volume expansion rate of the polymer particulate material is preferably 1.3 or smaller, more preferably 1.25 or smaller, and still more preferably 1.15 or smaller. The smaller the volume expansion rate of the polymer particulate material is, the more resistant to cracking or exfoliation the electroconductive layer of the electroconductive particulate material that includes the polymer particulate material is, even if the electroconductive particulate material is exposed to a step performed in a high temperature condition such as reflowing.
The volume expansion rate of the polymer particulate material can be calculated according to the following manner:
Firstly, the particle diameter of the polymer particulate material is measured. Secondly, a polymer particulate material is placed on a glass plate, and heated for 6 minutes with a hot plate, which is set to 260°C. After heating, the particle diameter of the polymer particulate material is measured. Based on the value thus-measured, the volume expansion rate can be calculated by the following formula:
$$(\text{Volume expansion rate}) = D2^3/D1^3$$

D1: Particle diameter of the polymer particulate material before heating
D2: Particle diameter of the polymer particulate material after heating

The average particle diameter of the polymer particulate material is preferably within the range of 0.1 to 1, 000 μm. The lower limit of the range of the average particle diameter is preferably 1 μm, more preferably 1.5 μm, particularly preferably 2 μm, and still more preferably 10 μm. The upper limit is preferably 500 μm, more preferably 300 μm, particularly preferably 60 μm, and still more preferably 30 μm. If the average particle diameter is very small, the polymer particulate material may aggregate on formation of an electroconductive layer on the surface of the polymer particulate material by electroless plating, which results in generation of aggregated electroconductive particles. In addition, connection reliability may decrease because contacting area of an electroconductive particle and an electrode becomes small if the electroconductive particle is used for connection of electrodes. If the particle is very large, undesirably large gaps may occur between electrodes.

The term "average particle diameter" used herein means a number average particle diameter. The average particle diameter can be measured by, for example, Coulter counter (manufactured by BECKMAN COULTER).

The CV value (coefficient of variation of particle size distribution) of the polymer particulate material is preferably 10% or smaller, more preferably 5% or smaller, and still more preferably 3% or smaller. If the CV value is very large, intervals of electrodes may tend to be uneven if the electroconductive particulate material is used for connecting electrodes.

The CV value can be calculated by the following formula, assuming that the standard deviation of the diameter of a polymer particle is p, and the average particle diameter of the particle is Dn:

$$\text{CV value } (\%) = (\rho/Dn) \times 100$$

As mentioned above, the surface of the polymer particulate material according to the present invention is then covered with an electroconductive layer, and the product may be suitably used as an electroconductive particulate material. Alternatively, the polymer particulate material according to the present invention may be suitably used as an impact absorber or a vibration dampener since the polymer particulate material has a high recovery rate from compression deformation. For example, the polymer particulate material may be used as a substitute of rubbers or springs or the like. Also, the polymer particulate material according to the present invention may be suitably used as a spacer for controlling gap intervals. For example, the polymer particulate material may be used as a spacer for liquid crystal panels.

(Electroconductive particulate material)

Fig. 1 is a cross-sectional view illustrating an electroconductive particle, in which the surface of the polymer particulate material of one embodiment of the present invention is covered with an electroconductive layer.

As illustrated in Fig. 1, electroconductive particulate material 1 includes polymer particulate material 2, and electroconductive layer 3 that covers the surface 2a of the polymer particulate material 2. The polymer particulate material 2 is a polymer particulate material obtained by copolymerizing comonomer components that includes the polyfunctional (meth) acrylate monomers and the monofunctional (meth)acrylate monomers. The recovery rate of polymer particulate material 2 from compression deformation is 70% or higher.

Electroconductive layer 3 is preferably made of a metal. The metal constituting electroconductive layer 3 is not particularly limited. Examples of the metal include gold, silver, copper, platinum, zinc, iron, lead, tin, aluminum, cobalt, indium, nickel, chromium, titanium, antimony, bismuth, germanium, and cadmium, and alloys of two or more of these metals. These metals may be used alone or may be used in combination of two or more species. Examples of the alloys include tin-lead alloy, tin-copper alloy, tin-silver alloy, and tin-lead-silver alloy.

Electroconductive layer 5 is preferably a nickel layer, a gold layer, a layer containing tin and silver, or a layer containing tin, silver, and copper. The layer containing tin and silver is preferably a tin-silver alloy layer. The layer containing tin, silver, and copper is preferably a tin-silver-copper alloy layer. The metal constituting the electroconductive layer 5 is preferably nickel, copper, gold, tin-silver alloy or a tin-silver-copper alloy.

The way for forming electroconductive layer 3 on the surface 2a of polymer particulate material 2 is not particularly limited. Examples of the way for forming electroconductive layer 3 include electroless plating, electroplating, physical vapor deposition, and coating of a pasty material that contains metal powder and an optional binder on the surface of

the polymer particulate material. Among them, electroless plating and electroplating are suitable. Examples of the above physical vapor deposition include vacuum deposition, ion plating, and ion sputtering.

Electroconductive layer 3 is constituted of a monolayer. As an alternative example illustrated in Fig. 2, the electroconductive layer may be constituted of a multilayer that includes two or more layers. Electroconductive particulate materials 6 as illustrated in Fig. 2 includes resin particle 2, first electroconductive layer 7 that covers the surface 2a of the resin particle 2, second electroconductive layer 8 that covers the surface of the electroconductive layer 7, and third electroconductive layer 9 that covers the surface of the electroconductive layer 8. The outer surface of the electroconductive layer is the third electroconductive layer 9. Thus, the electroconductive layer may have a multilayer structure.

The outer surface of the electroconductive layer in the electroconductive particulate material is preferably a nickel layer, a gold layer, or a palladium layer, and more preferably gold layer. Such layers may contribute to reduce connection resistance between electrodes in the case of connection of electrodes via the electroconductive particle.

The outer surface of the electroconductive layer of the electroconductive particulate material is preferably formed of a solder layer, as represented by tin-silver alloy. Once such solder layer is melted by heat, the solder layer contributes to firm bonding between electrodes and the electroconductive particulate material via metal bonding. Also, the surface of the electroconductive layer formed of a solder layer is resistant to temperature changes, and therefore, connection failure may not be caused even when the connection structure having a connection between electrodes via the electroconductive particulate material is placed in a cooling-heating cycle. The connection structure is also resistant to impact, and may not cause connection failure by impact.

The solder layer preferably contains tin and silver since electrodes and the electroconductive particulate material are able to connect to each other more firmly.

Preferable examples of such an electroconductive particulate material include electroconductive particulate materials having a nickel layer, a copper layer, and a solder layer deposited in this order on the surface 2a of polymer particulate material 2, electroconductive particulate materials having a nickel layer, and a gold layer deposited in this order on the surface 2a of polymer particulate material 2. Among them, the former electroconductive particulate materials having a nickel layer, a copper layer, and a solder layer deposited in this order is preferable since connection reliability of the connection structure is further increasable.

The thickness of the electroconductive layer is preferably within the range of 5 to 50, 000 nm. The lower limit of the range of the thickness is preferably 10 nm, and the upper limit is preferably 4,000 nm. If the thickness of the electroconductive layer is very thin, electroconductivity may be insufficient. On the contrary, if the thickness is very thick, the difference between thermal expansion of the polymer particulate material and that of the electroconductive layer becomes larger, and thus, the electroconductive layer may exfoliate from the polymer particulate material. In the case where the electroconductive layer constituted of two or more layers, the "thickness of the electroconductive layer" means a total thickness of all the layers.

The recovery rate of the electroconductive particulate material from compression deformation is preferably 80% or higher, more preferably 90% or higher, still more preferably 95% or higher, and most preferably 98% or higher. If the recovery rate from compression deformation is very low, the electroconductive layer may easily exfoliate from the polymer particulate material.

(Anisotropic conductive material)

The anisotropic conductive material according to the present invention includes an electroconductive particle and a binder resin.

The binder resin is not particularly limited. Generally, insulating resins are used as the binder resin. Examples of the binder resin include vinyl resins, thermoplastic resins, setting resins, thermoplastic block copolymers, and elastomers. The binder resins may be used singly, or in combination of two or more species.

Examples of the vinyl resins include vinyl acetate resins, acrylate resins, and styrene resins. Examples of the thermoplastic resins include polyolefin resins, ethylene-vinyl acetate copolymer, and polyamide resins. Examples of the setting resins include epoxy resins, urethane resins, polyimide resins, and unsaturated polyester resins. The setting resin may be a room temperature-setting adhesive resin, a thermosetting resin, a light-setting resin, or a moisture-setting resin. The setting resin may be used in combination of a curing agent. Examples of the thermoplastic block copolymers include styrene-butadiene-styrene block copolymer, styrene-isoprene-styrene block copolymer, hydrogenated styrene-butadiene-styrene block copolymer, and hydrogenated styrene-isoprene-styrene block copolymer. Examples of the elastomers include styrene-butadiene copolymer rubber, and acrylonitrile-styrene block copolymer rubber.

The anisotropic conductive material may contain a variety of additives such as fillers, expanders, softeners, plasticizers, polymerization catalysts, curing catalysts, coloring agents, antioxidants, thermal stabilizers, light stabilizers, UV absorbers, lubricants, antistatic agents, or flame retardants, in addition to the electroconductive particulate material and the binder resin.

The electroconductive particulate material may be dispersed in a binder resin by a conventionally known method,

and the method for dispersion is not particularly limited. Examples of the method for dispersing the electroconductive particulate material in the binder resin include a method which includes dispersing adding the electroconductive particulate material in the binder resin and kneading the mixture with a planetary mixer; a method which includes homogeneously dispersing the electroconductive particulate material in water or an organic solvent with a homogenizer, etc., then adding the dispersion in the binder resin, and kneading the mixture with a planetary mixer; and a method which includes diluting the binder resin in water or a organic solvent, etc., then adding electroconductive particulate material in the dilution, and then kneading the mixture with a planetary mixer.

The anisotropic conductive material according to the present invention may be used as anisotropic conductive pastes, anisotropic conductive inks, anisotropic conductive adhesives, anisotropic conductive films, anisotropic conductive sheets, and the like. If the anisotropic conductive material containing the electroconductive particulate material is used as the film or sheet-like adhesives such as anisotropic conductive films or anisotropic conductive sheets, another film-like or sheet-like adhesives that do not contain any electroconductive particulate materials may be laminated with a film-like or sheet-like adhesive that contains an electroconductive particulate material.

(Connection structure)

Fig. 3 is a front cross-sectional view illustrating a connection structure. The connection structure includes the electroconductive particle in which the surface of the polymer particulate material of one embodiment of the present invention is covered with an electroconductive layer.

Connection structure 11 as illustrated in Fig. 3 includes electroconductive particulate material 6 that has a solder layer. The electroconductive particulate material 6 are schematically illustrated in Fig. 3.

Connection structure 11 as illustrated in Fig. 3 includes circuit board 12 as a first member to be connected, semiconductor chip 14 as a second member to be connected, and connection part 13 that connects the first member 12 and the second member 14. Connection part 13 includes electroconductive particulate material 6.

In the production of the connection structure 11, electrode termini are formed by, for example, providing a semiconductor chip 14 with two or more electrodes 14a, mounting the electroconductive particulate material 6, which has a solder layer, on the electrodes 14a via a flux, and melting the solder layer with heating. A circuit board 12 with two or more electrodes 12a, similarly to the semiconductor chip, is separately provided. The semiconductor chip 14 with the electroconductive particulate material 6, on which electrode termini are formed, is laminated on the circuit board 12 via solder paste such that electrode termini of the semiconductor chip 14 contacts with the electrodes 12a of the circuit board 12. Then, the solder layer of the electroconductive particulate material 6 is re-melted with heating, to give the connection structure 11. Solder paste is optional for connection between the semiconductor chip 14 and the circuit board 12.

Specific examples of the connection structure include a connection structure that include a circuit board, and electronic chips such as a semiconductor chip, a capacitor chip or a diode chip mounted on the circuit board, the electrodes of the electronic chips being electrically connected to electrodes on the circuit board. Examples of the circuit board include printed boards such as flexible printed boards, glass boards, and metallic foil-laminated circuit boards.

The method for manufacturing the connection structure is not particularly limited. One example of the method for manufacturing the connection structure includes the steps of disposing the anisotropic conductive material between a first member to be connected, such as an electronic parts or a circuit board, and a second member to be connected, such as electronic parts or a circuit board, laminating the assembly to form a laminated body, and pressing the laminated body with heating.

Hereafter, the present invention will be explained specifically referring to Examples and Comparative Examples. The scope of the present invention is not limited within the range of the Examples described below.

In the production of the polymer particulate material, the monomers mentioned below were used as (meth) acrylate monomers:

(1) Monofunctional (meth)acrylate monomers

LA: Lauryl acrylate
SA: Stearyl acrylate
IAA: Isoamyl acrylate
BZA: Benzyl acrylate
ISA: Isostearyl acrylate
2EHA: 2-Ethylhexyl acrylate

(2) Bifunctional (meth)acrylate monomers

A-DOD: 1,10-Decanediol diacrylate
1,6HX-A: 1,6-Hexanediol diacrylate
1,9ND-A: 1,9-Nonandiol diacrylate

(3) Trifunctional (meth)acrylate monomers

TMPTA: Trimethylolpropane triacrylate

(4) Tetrafunctional (meth)acrylate monomers

PTA: Pentaerythritol tetraacrylate

(Example 1)

In a homogeneous dispersion prepared from 835 parts by weight of ion-exchanged water and 1124 parts by weight of a 5.5 wt% aqueous solution of polyvinyl alcohol, 55 parts by weight of lauryl acrylate (LA), 45 parts by weight of pentaerythritol tetraacrylate (PTA), and 3.1 parts by weight of PERBUTYL O (produced by NOF corporation), as a polymerization initiator, were mixed, and then droplets controlled to have a particle diameter of 240 μm were added, to prepare a mixture.

Under nitrogen atmosphere, thus-prepared mixture was polymerized at 70°C for 5 hours. Then, particles in the resultant mixture were separated by suction filtration. The particles were washed with ion-exchanged water and acetone, to completely remove solvent medium. The particles were then dried, to give a polymer particulate material.

(Examples 2 to 7 and Comparative Example 1)

A polymer particulate material was prepared in the same manner as Example 1 except that the proportions of lauryl acrylate (LA) and pentaerythritol tetraacrylate (PTA) were changed as listed in Table 1 below.

(Comparative Example 2)

A resin particulate material (particle diameter: 240 μm) formed from divinylbenzene and pentaerythritol tetraacrylate (weight ratio: 5:5) was prepared.

(Example 8)

A mixture of 65 parts by weight of lauryl acrylate (LA), 35 parts by weight of pentaerythritol tetraacrylate (PTA), and 3.1 parts by weight of PERBUTYL O (produced by NOF corporation) was prepared, and the mixture was polymerized via suspension polymerization in a 1 wt% aqueous solution of polyvinyl alcohol. The obtained particulate material was classified, to give a polymer particulate material.

(Evaluations of Examples 1 to 8 and Comparative Example 1 and 2)

(1) Compression modulus (10%K value) of a polymer particulate material

Compression moduli (10%K value) of prepared polymer particulate materials were measured according to the manner mentioned above with a Micro Compression Testing Machine (manufactured by Shimadzu Corporation, PCT-100)

(2) Recovery rate of a polymer particulate material from compression deformation

Recovery rate of each of prepared polymer particulate materials from compression deformation was measured with a Micro Compression Testing Machine (manufactured by Shimadzu Corporation, PCT-100)

(3) Volume expansion rate of a polymer particulate material

One particle of the polymer particulate materials was placed on a glass plate, and heated for 6 minutes with a hot plate, which was set to 260°C. The particle diameters of the polymer particulate material were measured both before and after heating. Based on the particle diameters measured, volume expansion rate was determined by the above-mentioned formula.

(4) Specific gravity of a polymer particulate material

The specific gravities of the polymer particulate materials were measured using a Micromeritics Gas Pycnometer (manufactured by Shimadzu Corporation, "Accupyc 1330") under helium gas atmosphere at a pressure of 0.15 to 0.17 MPa. Polymer particulate materials with a specific gravity of 1.05 or larger were regarded as acceptable products.
The results are shown in the below Table 1.

Table 1

| | Ex. 1 | Ex. 2 | Ex. 3 | Ex. 4 | Ex. 5 | Ex. 6 | Ex. 7 | Ex. 8 | Comp. Ex. 1 | Comp. Ex. 2 |
|---|---|---|---|---|---|---|---|---|---|---|
| Blended amount of LA (part(s) by weight) | 55 | 45 | 30 | 8 | 65 | 75 | 80 | 65 | 85 | - |
| Blended amount of PTA (part(s) by weight) | 45 | 55 | 70 | 92 | 35 | 25 | 20 | 35 | 15 | - |
| Particle diameter (μm) | 240 | 240 | 240 | 240 | 240 | 240 | 240 | 30 | 240 | 240 |
| 10%K value (N/mm2) | 468 | 1005 | 1372 | 2703 | 351 | 280 | 235 | 360 | 212 | 3690 |
| Recovery rate from compression deformation | 94.5 | 92.6 | 95.3 | 86.9 | 92.8 | 91.0 | 98.2 | 92.1 | 99.3 | 97.1 |
| Volume expansion rate | 1.10 | 1.10 | 1.01 | 1.02 | 1.10 | 1.10 | 1.10 | 1.1 | 1.10 | 1.09 |
| Specific gravity | 1.10 | 1.12 | 1.17 | 1.27 | 1.07 | 1.06 | 1.05 | 1.07 | 1.03 | 1.19 |

(Example 9)

On the surface of the polymer particulate material prepared in Example 5, a base nickel-plated layer with a thickness of 0.3 μm was formed by electroless nickel plating. Then, a copper layer with a thickness of 10 μm was formed on the surface of the base nickel-plated layer by copper electroplating. Subsequently, a solder layer containing tin and silver (tin : silver = 96.5 : 3.5 (in terms of % by weight)) with a thickness of 25 μm was formed on the surface of the copper layer using an electroplating solution that contained tin and silver via electroplating. Thus, electroconductive particulate materials that included a polymer particulate material, and a nickel layer, a copper layer, and a solder layer deposited in this order on the surface of the polymer particulate material was obtained. The particle diameter of the thus-obtained electroconductive particulate material was 310 μm.

(Comparative Example 3)

An electroconductive particulate material (Microperl SOL, produced by Sekisui Chemical Co., Ltd., particle diameter: 310 μm) was provided. The electroconductive particulate material had, on the surface of the resin particle obtained in Comparative Example 2, a nickel layer with a thickness of 0.3 μm, a copper layer with a thickness of 10 μm,

and solder layer with a thickness of 25 μm (the solder layer contained tin and silver (tin : silver = 96.5 : 3.5 (in terms of % by weight)) were deposited in this order.

(Comparative Example 4)

Solder balls formed of tin, silver, and copper (M705, produced by Senju Metal Industry Co. , Ltd., particle diameter: 300 μm, tin : silver : copper = 96.5 : 3.0 : 0.5 (in terms of % by weight) were provided.

(Evaluation of Example 9 and Comparative Example 3 and 4)

(1) Construction of connection structures

A silicon chip (4.5 mm long, 4.5 mm wide, and 0.3 mm thick) was provided. The silicon chip had, on one surface thereof, 81 electrodes that were spaced from one another at an interval of 0.5 mm in both length and width direction.

On the each electrode of the silicon chip, one electroconductive particle of Example 9 was placed (one particle/one electrode) via flux, and then heated at 250°C for 20 seconds, to produce electrode termini. Separately, a glass epoxy board (FR-4, 77 mm long, 132 mm wide, 1. 0 mm thick), which had electrodes thereon as the silicon chip, was provided. The silicon chip with electrode termini formed thereon was laminated on the glass epoxy board via solder paste (produced by Senju Metal Industry Co. , Ltd., M705-GNR-K2-V) such that the electrode termini on the silicon chip and electrodes on the glass epoxy board were contacted with each other. Then, solder was heated at 250°C for 20 seconds to be molten form, to produce a connection structure that included electroconductive particulate material of Example 9. Alternatively, another connection structure that included the solder ball of Comparative Example 3 was prepared in the same manner as mentioned above except that the solder ball of Comparative Example 3 was used in place of the electroconductive particle of Example 9. Also, another connection structure that included the solder ball of Comparative Example 4 was prepared in the same manner as mentioned above except that the solder ball of Comparative Example 4 was used in place of the electroconductive particle of Example 9.

(2) Thermal cycling test

The thus-prepared connection structures were tested by a 1500-cycle thermal cycling test, each cycle including storage at -40°C for 10 minutes, and then 125°C at 10 minutes. Resistance between the electrodes was measured after every cycle to check the presence of connection failure between the electrodes. Frequencies of thermal cycles at the time when a connection failure occurred are listed in Table 2 below. Also in Table 2, samples free of any connection failure even after 1500 cycles of thermal cycling test are represented by the criterion "o". This evaluation was made for each of 4 connection structures.

(3) Drop impact test

Drop impact tests on the prepared connection structure was performed with Drop Impact Tester (produced by Hitachi Technologies and Services, Ltd., "FIT-1500A"), at an impact acceleration of 2900 G. Resistance between the electrodes was measured after every drop of the connection structure to check the presence of connection failure between the electrodes. Drop frequency at the time when a connection failure occurred are listed in Table 2 below. This evaluation was made for each three connection structures.

[Table 2]

| | | | | | |
|---|---|---|---|---|---|
| Thermal cycling test | Connection structure No. | 1 | 2 | 3 | 4 |
| | Ex. 9 | 1202 | O | O | O |
| | Comp. Ex. 3 | 824 | 932 | 1016 | 1132 |
| | Comp. Ex. 4 | 412 | 483 | 501 | 529 |
| Drop impact test | Connection structure No. | 1 | 2 | 3 | |
| | Ex. 9 | 239 | 278 | 292 | |
| | Comp. Ex. 3 | 162 | 179 | 213 | |
| | Comp. Ex. 4 | 32 | 41 | 53 | |

It is found from the results illustrated in Table 2 that connection structures including the electroconductive particle of Example 9 were resistant to connection failure between electrodes even if thermal variation in the thermal cycle or impact was applied thereto.

(Example 10)

In a homogenous dispersion prepared from 835 parts by weight of ion-exchanged water and 1124 parts by weight of a 5.5 wt% aqueous solution of polyvinyl alcohol, 50 parts by weight of lauryl acrylate (LA), 50 parts by weight of 1, 10-decanediol diacrylate (A-DOD), and 3.1 parts by weight of PERBUTYL O (produced by NOF corporation), as a polymerization initiator, were mixed, and then droplets controlled to have a particle diameter of 240 μm were added, to prepare a mixture.

Under nitrogen atmosphere, thus-prepared mixture was polymerized at 70°C for 5 hours. Then, particles in the resultant mixture were separated by suction filtration. The particles were washed with ion-exchanged water and acetone, to completely remove solvent medium. The particles were then dried, to give a polymer particulate material.

(Examples 11 to 16 and Comparative Example 5 to 8)

A polymer particulate material was prepared in the same manner as Example 10 except that (meth) acrylate monomer (listed in Tables 3 and 4) at the ratio as illustrated in Tables 3 and 4 in place of 50 parts by weight of lauryl acrylate (LA) and 50 parts by weight of 1,10-decanediol diacrylate (A-DOD).

(Comparative Example 9)

A polymer particulate material was prepared in the same manner as Example 10 except that (meth) acrylate monomer (listed in Table 4) at the ratio as illustrated in Table 4 below was used in place of 50 parts by weight of lauryl acrylate (LA) and 50 parts by weight of 1,10-decanediol diacrylate (A-DOD), as well as 2, 2-azobisisobutyronitrile (AIBN) was used in place of PERBUTYL O as a polymerization initiator.

(Example 17)

A mixture of 50 parts by weight of lauryl acrylate (LA), 50 parts by weight of 1,10-decanediol diacrylate (A-DOD), and 3. 1 parts by weight of PERBUTYL O (produced by NOF corporation) was prepared, and the mixture was polymerized via suspension polymerization in a 1 wt% aqueous solution of polyvinyl alcohol. The obtained particulate material was classified, to produce a polymer particulate material.

(Evaluation of Examples 10 to 17 and Comparative Example 5 to 9)

In the same manner as Examples 1 to 8 and Comparative Examples 1 and 2, each particulate sample was tested on (1) compression modulus (10%K value) of a polymer particulate material, (2) recovery rate of a polymer particulate material from compression deformation, and (3) volume expansion rate of a polymer particulate material.
The results are illustrated in Tables 3 and 4 below.
[Table 3]

| | | Ex. 10 | Ex. 11 | Ex. 12 | Ex. 13 | Ex. 14 | Ex. 15 | Ex. 16 | Ex. 17 |
|---|---|---|---|---|---|---|---|---|---|
| Component | Type of monofunctional (meth)acrylate monomer | LA | LA | LA | LA | SA | IAA | ISA | LA |
| | Blended amount of monofunctional (meth)acrylate monomer (wt%) | 50 | 30 | 10 | 70 | 50 | 50 | 50 | 50 |
| | Type of bifunctional (meth)acrylate monomer | A-DOD | A-DOD | A-DOD | A-DOD | A-DOD | A-DOD | A-DOD | A-DOD |
| | Blended amount of bifunctional (meth)acrylate monomer (wt%) | 50 | 70 | 90 | 30 | 50 | 50 | 50 | 50 |
| | Type of polymerization initiator | PERBUTYL O | PERBUTYL O | PERBUTYL O | PERBUTYL O | PERBUTYL O | PERBUTYL O | PERBUTYL O | PERBUTYL O |
| Evaluation | Particle diameter (μm) | 240 | 240 | 240 | 240 | 240 | 240 | 240 | 30 |
| | 10%K value ($N/mm^2$) | 77.4 | 227.4 | 306.7 | 60.8 | 89.2 | 73.5 | 139.2 | 79.4 |
| | Recovery rate from compressive deformation (%) | 98 | 84 | 82 | 99 | 99 | 93 | 80 | 98 |
| | Volume expansion rate | 1.08 | 1.09 | 1.13 | 1.24 | 1.05 | 1.09 | 1.06 | 1.10 |

[Table 4]

| | | Comp. Ex. 5 | Comp. Ex. 6 | Comp. Ex. 7 | Comp. Ex. 8 | Comp. Ex. 9 |
|---|---|---|---|---|---|---|
| Component | Type of monofunctional (meth)acrylate monomer | BZA | – | – | – | 2EHA |
| | Blended amount of monofunctional (meth)acrylate monomer (wt/%) | 50 | – | – | – | 50 |
| | Type of bifunctional (meth)acrylate monomer | A–DOD | A–DOD | 1, 6HX–A | 1, 9ND–A | 1, 9ND–A |
| | Blended amount of bifunctional (meth)acrylate monomer (wt/%) | 50 | 100 | 100 | 100 | 50 |
| | Type of polymerization initiator | PERBUTYL O | PERBUTYL O | PERBUTYL O | PERBUTYL O | AIBN |
| Evaluation | Particle diameter (μm) | 240 | 240 | 240 | 240 | 240 |
| | 10%K value (N/mm$^2$) | 441.0 | 605.6 | 1271.1 | 712.5 | 2.9 |
| | Recovery rate from compressive deformation (%) | 40 | 79 | 82 | 81 | 63 |
| | Volume expansion rate | 1.16 | 1.29 | 1.35 | 1.36 | 1.12 |

*2,2'-Azobisisobutyronitrile (AIBN)

Fig. 4(a) illustrates the result of measurement of compression modulus (10%K value) of polymer particulate material of Example 10. Fig. 4(b) illustrates the result of measurement of the recovery rate of polymer particulate material of Example 10 from compression deformation.

Fig. 5(a) illustrates the result of measurement of compression modulus (10%K value) of polymer particulate material of Example 14. Fig. 5(b) illustrates the result of measurement of the recovery rate of polymer particulate material of Example 14 from compression deformation.

Fig. 6(a) illustrates the result of measurement of compression modulus (10%K value) of polymer particulate material of Comparative Example 5. Fig. 6(b) illustrates the result of measurement of the recovery rate of polymer particulate material of Comparative Example 5 from compression deformation.

Fig. 7(a) illustrates the result of measurement of compression modulus (10%K value) of polymer particulate material of Comparative Example 6. Fig. 7(b) illustrates the result of measurement of the recovery rate of polymer particulate material

of Comparative Example 6 from compression deformation.

(Example 18)

In a homogeneous dispersion of 835 parts by weight of ion-exchanged water and 1124 parts by weight of a 5.5 wt% aqueous solution of polyvinyl alcohol, 50 parts by weight of lauryl acrylate (LA), 50 parts by weight of trimethylolpropane triacrylate (TMPTA), and 3.1 parts by weight of PERBUTYL O (product of NOF corporation), as a polymerization initiator, were added and mixed, to form a mixture.

Under nitrogen atmosphere, the mixture was polymerized at 70°C for 5 hours. Then, particles in the resultant mixture were separated by suction filtration. The particles were washed with ion-exchanged water and acetone, to completely remove solvent medium. The particles were then dried, to give a polymer particulate material.

(Examples 19 to 21)

A polymer particulate material was prepared in the same manner as Example 18 except that the amounts of lauryl acrylate (LA) and trimethylolpropane triacrylate (TMPTA) to be blended were changed as illustrated in Table 5 below.

(Evaluation of Examples 18 to 21)

In the same manner to the evaluation of Examples 1 to 8 and Comparative Examples 1 and 2, each particulate sample was tested on (1) compression modulus (10%K value) of polymer particulate materials, (2) recovery rate of polymer particulate materials from compression deformation, and (3) volume expansion rate of the polymer particulate materials.
The results are illustrated in Table 5 below.

[Table 5]

| | | Ex. 18 | Ex. 19 | Ex. 20 | Ex. 21 |
|---|---|---|---|---|---|
| Component | Type of monofunctional (meth)acrylate monomer | LA | LA | LA | LA |
| | Blended amount of monofunctional (meth)acrylate monomer(wt/%) | 50 | 30 | 10 | 70 |
| | Type of trifunctional (meth)acrylate monomer (wt/%) | TMPTA | TMPTA | TMPTA | TMPTA |
| | Blended amount of trifunctional (meth)acrylate monomer (wt/%) | 50 | 70 | 90 | 30 |
| | Type of polymerization initiator | PERBUTYL O | PERBUTYL O | PERBUTYL O | PERBUTYL O |
| Evaluation | Particle diameter (μm) | 240 | 240 | 240 | 240 |
| | 10%K value ($N/mm^2$) | 1211 | 748 | 236 | 152 |
| | Recovery rate from compressive deformation (%) | 97 | 91 | 86 | 99 |
| | Volume expansion rate | 1.05 | 1.05 | 1.10 | 1.09 |

Explanation of Symbols

| | |
|---|---|
| 1 | Electroconductive particulate material |
| 2 | Polymer particulate material |
| 2a | Surface |
| 3 | Electroconductive layer |
| 6 | Electroconductive particulate material |
| 7 | First electroconductive layer |
| 8 | Second electroconductive layer |
| 9 | Third electroconductive layer |
| 11 | Connection structure |
| 12 | Circuit board |
| 12a | Electrode |
| 13 | Connection part |

14 Semiconductor chip
14a Electrode

## Claims

**1.** A polymer particulate material obtainable by co-polymerizing comonomer components comprising:

at least one polyfunctional (meth) acrylate selected from the group consisting of a bifunctional (meth) acrylate monomer having a structure represented by the below formula (1), a trifunctional (meth)acrylate monomer having a structure represented by the below formula (2), and a tetrafunctional (meth)acrylate monomer having a structure represented by the below formula (3); and
a monofunctional (meth)acrylate monomer having a structure represented by the below formula (4),
wherein, if the at least one polyfunctional (meth)acrylate comprises the tetrafunctional (meth)acrylate monomer having a structure represented by the below formula (3), the comonomer components comprises 80% by weight or less of the monofunctional (meth) acrylate monomer in 100% by weight as the total weight of the tetrafunctional (meth) acrylate monomer and the monofunctional (meth)acrylate monomer, and
the polymer particulate material shows a recovery rate from compressive deformation of 70% or higher;

[Chemical formula 1]

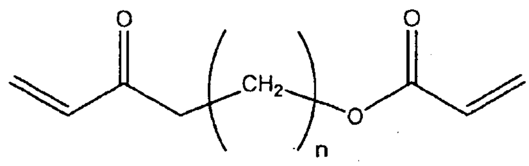

··· Formula (1)

in the formula (1), n represents an integer within the range of 4 to 10;

[Chemical formula 2]

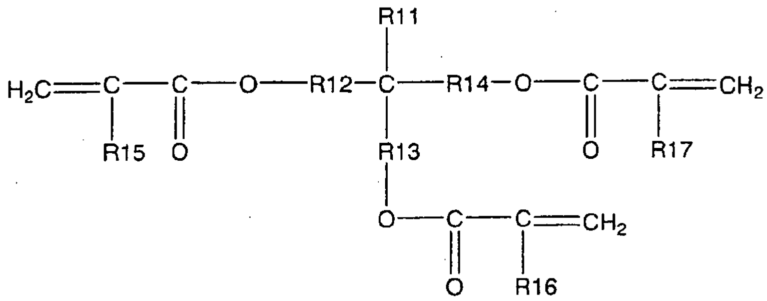

··· Formula (2)

in the formula (2), R11 represents a hydrogen atom or a C1-4 alkyl group, R12, R13 and R14 each represent a C1-4 alkylene group, and R15, R16 and R17 each represent a hydrogen atom or a methyl group;

[Chemical formula 3]

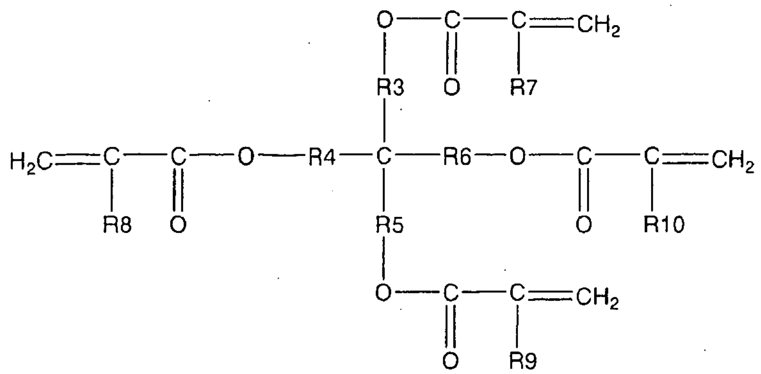

··· Formula (3)

in the formula (3), R3, R4, R5 and R6 each represent a C1-4 alkylene group, and R7, R8, R9 and R10 each represent a hydrogen atom or a methyl group; and

[Chemical formula 4]

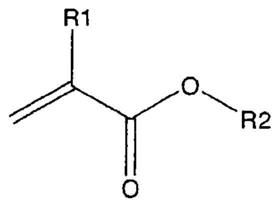

··· Formula (4)

in the formula (4), R1 represents a hydrogen atom or a methyl group, and R2 represents a C5-18 alkyl group, wherein the alkyl group may have a linear structure or a branched chain structure.

**2.** The polymer particulate material according to claim 1,
wherein the polyfunctional (meth)acrylate is the tetrafunctional (meth)acrylate monomer.

**3.** The polymer particulate material according to claim 1 or 2,
wherein the comonomer components comprises 70% by weight or less of the monofunctional (meth) acrylate monomer in the 100% by weight as the total weight of the tetrafunctional (meth)acrylate monomer and the monofunctional (meth)acrylate monomer.

**4.** The polymer particulate material according to any one of claims 1 to 3,
wherein the monofunctional (meth)acrylate monomer is at least one of the group selected from the group consisting of lauryl (meth)acrylate, stearyl (meth)acrylate, isostearyl (meth)acrylate, and isoamyl (meth)acrylate.

**5.** The polymer particulate material according to claim 4,
wherein the monofunctional (meth) acrylate monomer is at least one of lauryl (meth) acrylate and stearyl (meth) acrylate.

**6.** The polymer particulate material according to claim 1,
wherein the polyfunctional (meth)acrylate is the bifunctional (meth)acrylate monomer.

**7.** The polymer particulate material according to any one of claims 1 to 6,

wherein the comonomer components comprises the monofunctional (meth)acrylate monomer in an amount within the range of 10 to 400 parts by weight relative to 100 parts by weight of the bifunctional (meth)acrylate monomer.

**8.** The polymer particulate material according to claim 1,
wherein the polyfunctional (meth)acrylate is the trifunctional (meth)acrylate monomer.

**9.** An electroconductive particulate material, which comprises:

the polymer particulate material according to any one of claims 1 to 8, and
an electroconductive layer that covers the surface of the polymer particulate material.

**10.** The electroconductive particulate material according to claim 9,
wherein the outer surface of the electroconductive layer is a solder layer.

**11.** An anisotropic conductive material, which comprises
the electroconductive particulate material according to claim 9 or 10, and
a binder resin.

**12.** A connection structure, which comprises
a first member to be connected;
a second member to be connected; and
a connection part that electrically connects the first member and the second member,
the connection part being formed from the electroconductive particulate material according to claim 9 or 10, or an anisotropic conductive material that comprises the electroconductive particulate material and a binder resin.

[FIG. 1]

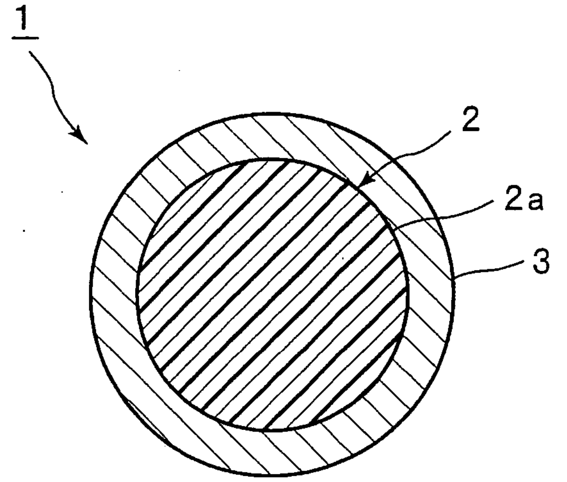


[FIG. 2]

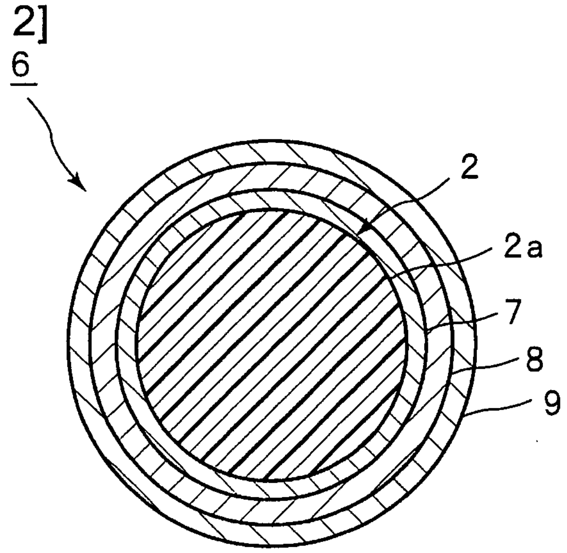


[FIG. 3]

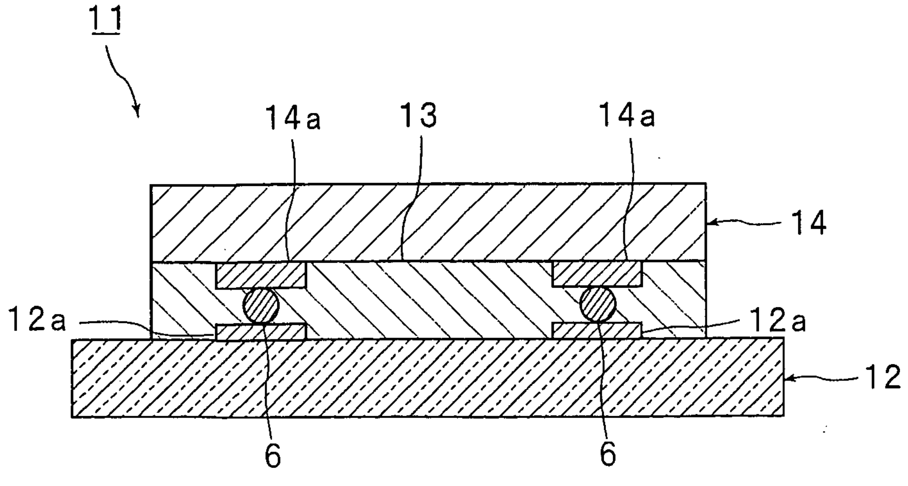

[FIG. 4]

(a)

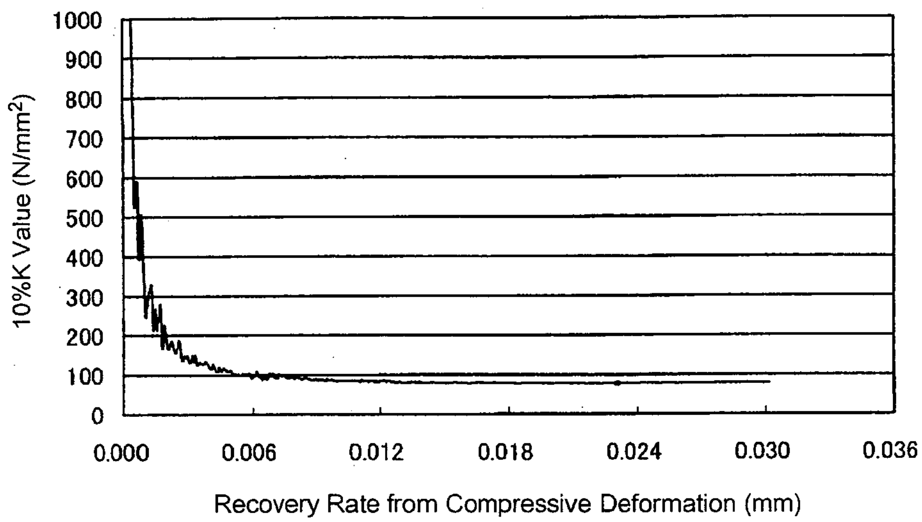
1000
900
800
700
600
500
400
300
200
100
0
10%K Value (N/mm²)
0.000
0.006
0.012
0.018
0.024
0.030
0.036
Recovery Rate from Compressive Deformation (mm)

(b)

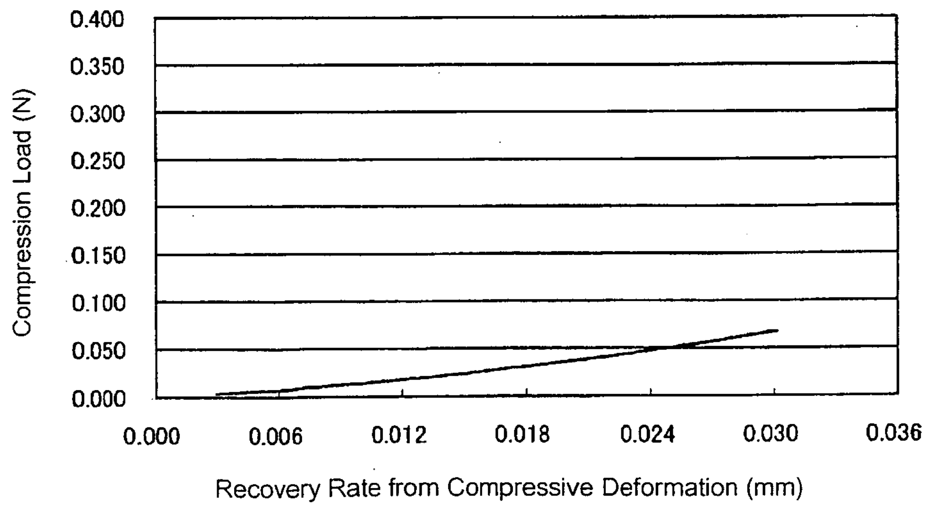
0.400
0.350
0.300
0.250
0.200
0.150
0.100
0.050
0.000
Compression Load (N)
0.000
0.006
0.012
0.018
0.024
0.030
0.036
Recovery Rate from Compressive Deformation (mm)

[FIG. 5]

(a)

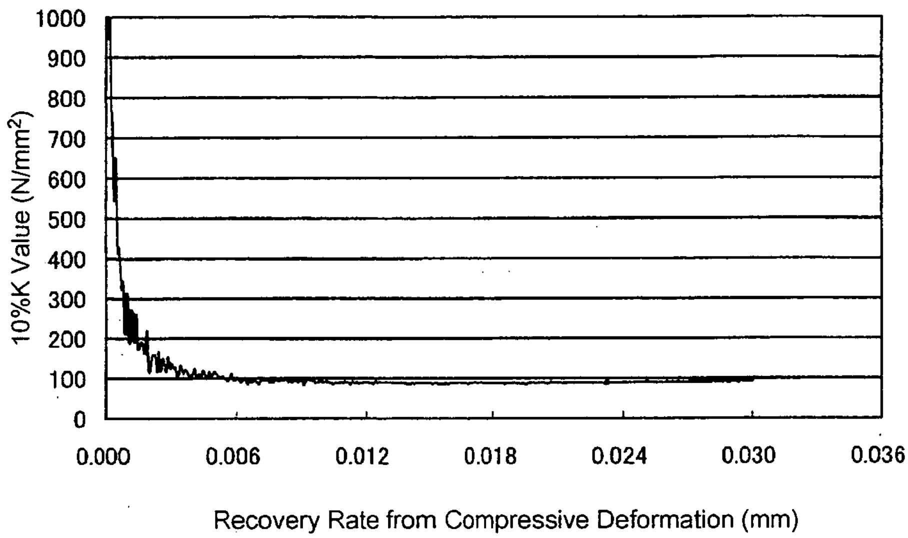
1000
900
800
700
600
500
400
300
200
100
0
10%K Value (N/mm$^2$)
0.000
0.006
0.012
0.018
0.024
0.030
0.036
Recovery Rate from Compressive Deformation (mm)

(b)

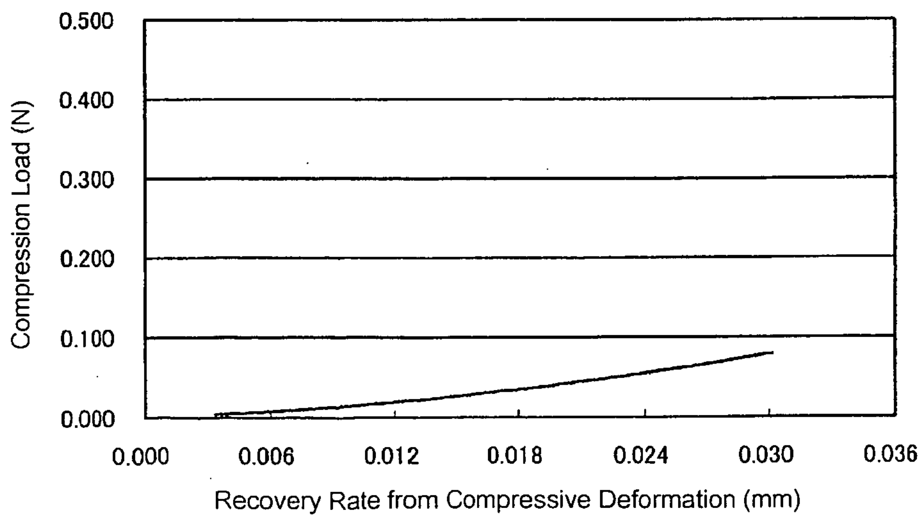
0.500
0.400
0.300
0.200
0.100
0.000
Compression Load (N)
0.000
0.006
0.012
0.018
0.024
0.030
0.036
Recovery Rate from Compressive Deformation (mm)

[FIG. 6]

(a)

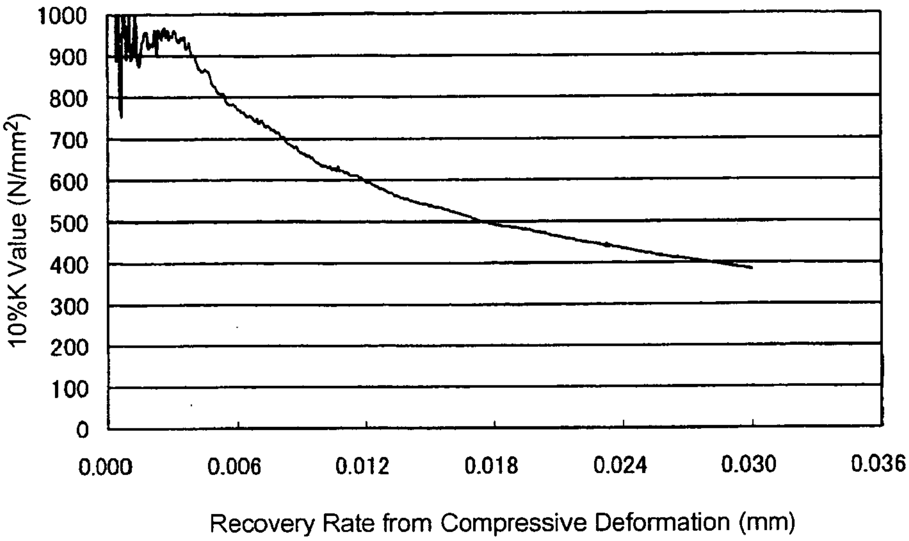
1000
900
800
700
600
500
400
300
200
100
0
10%K Value (N/mm2)
0.000
0.006
0.012
0.018
0.024
0.030
0.036
Recovery Rate from Compressive Deformation (mm)

(b)

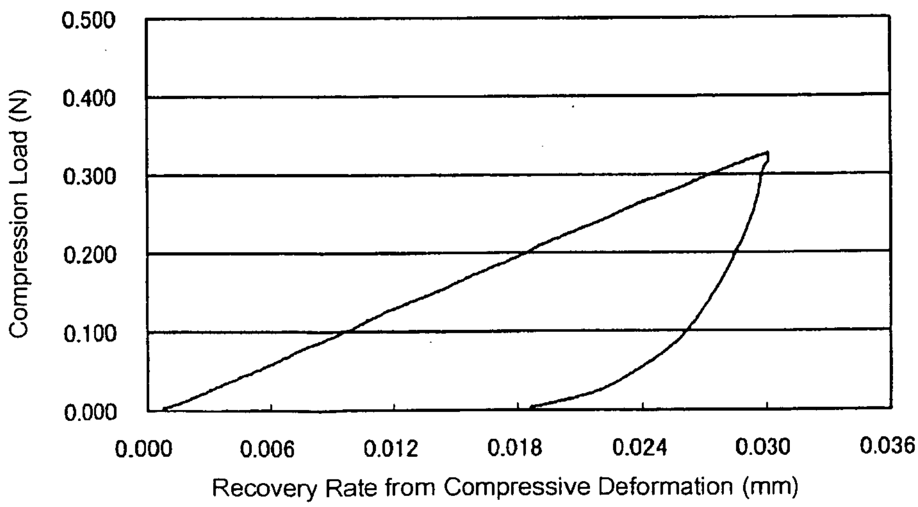
0.500
0.400
0.300
0.200
0.100
0.000
Compression Load (N)
0.000
0.006
0.012
0.018
0.024
0.030
0.036
Recovery Rate from Compressive Deformation (mm)

[FIG. 7]

(a)

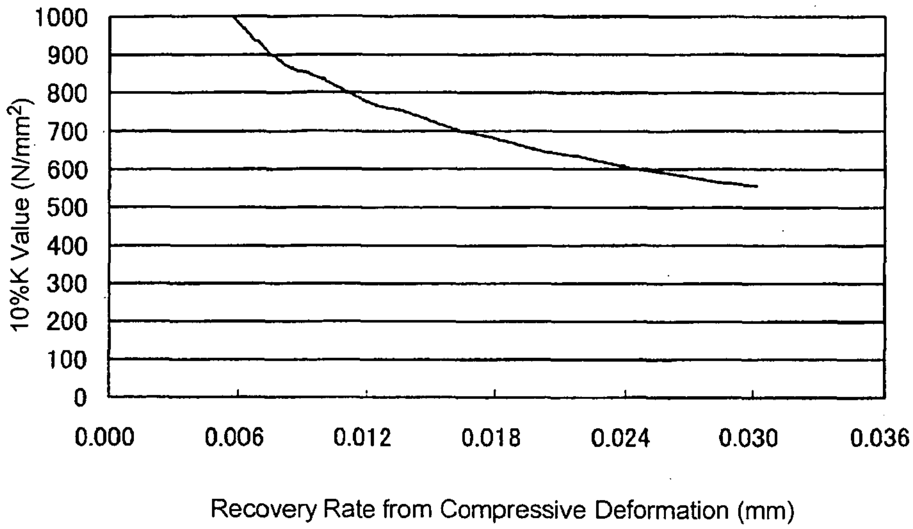
1000
900
800
700
600
500
400
300
200
100
0
10%K Value (N/mm$^2$)
0.000
0.006
0.012
0.018
0.024
0.030
0.036
Recovery Rate from Compressive Deformation (mm)

(b)

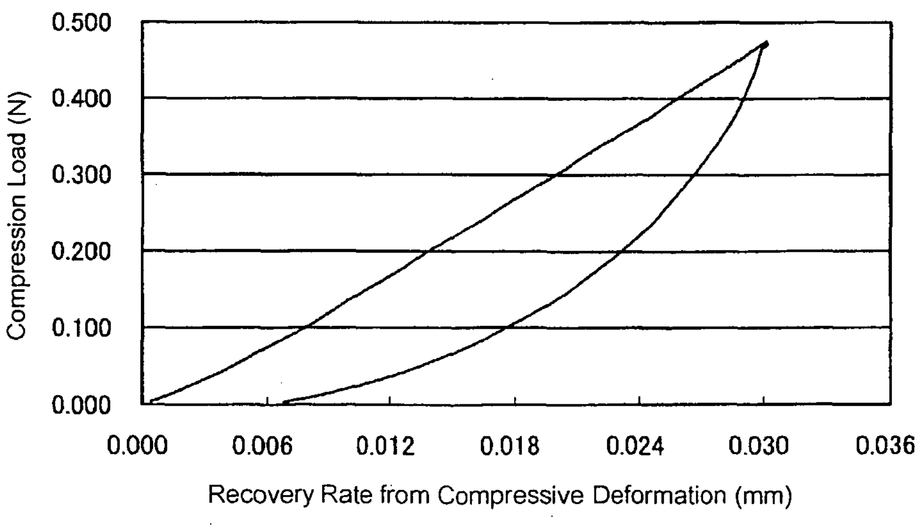
0.500
0.400
0.300
0.200
0.100
0.000
Compression Load (N)
0.000
0.006
0.012
0.018
0.024
0.030
0.036
Recovery Rate from Compressive Deformation (mm)

## INTERNATIONAL SEARCH REPORT

International application No.
PCT/JP2009/063339

A. CLASSIFICATION OF SUBJECT MATTER
C08F220/10(2006.01)i, C08J3/12(2006.01)i

According to International Patent Classification (IPC) or to both national classification and IPC

B. FIELDS SEARCHED

Minimum documentation searched (classification system followed by classification symbols)
C08F20/00-70, C08F2/00-60, C08J3/00-28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2002-322203 A (Sekisui Chemical Co., Ltd.), 08 November 2002 (08.11.2002), claims 1 to 3; paragraphs [0007], [0014], [0015], [0019] (Family: none) | 1-5,8<br>9-12<br>6,7 |
| X<br>Y<br>A | JP 8-501587 A (Minnesota Mining & Manufacturing Co.), 20 February 1996 (20.02.1996), claims 1 to 10; pages 19 to 20, examples 6, 10 & US 5238736 A & WO 1994/006834 A1 | 1,4-7<br>9-12<br>2,3,8 |
| Y | JP 2002-145935 A (Hayakawa Rubber Co., Ltd.), 22 May 2002 (22.05.2002), claims 1 to 9 (Family: none) | 9-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 October, 2009 (17.10.09) | 27 October, 2009 (27.10.09) |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.
PCT/JP2009/063339

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-355601 A (Sekisui Chemical Co., Ltd.), 26 December 2000 (26.12.2000), claims 1 to 8 (Family: none) | 9-12 |
| Y | JP 2000-319309 A (Sekisui Chemical Co., Ltd.), 21 November 2000 (21.11.2000), claims 1 to 6 (Family: none) | 9-12 |
| A | JP 2004-244420 A (Rohm and Haas Co.), 02 September 2004 (02.09.2004), claims 1 to 10 & EP 1447074 A2 & KR 10-2004-0073388 A & CN 1522690 A | 1-12 |
| A | JP 2004-117564 A (Sekisui Chemical Co., Ltd.), 15 April 2004 (15.04.2004), claims 1 to 3 (Family: none) | 1-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 03104285 A